**Europäisches Patentamt**

**European Patent Office**

**Office européen des brevets**

(19)

(11) Veröffentlichungsnummer: **0 344 347 B1**

(12)
# EUROPÄISCHE PATENTSCHRIFT

(45) Veröffentlichungstag der Patentschrift: **29.12.93**

(51) Int. Cl.⁵: **G06F 7/544**

(21) Anmeldenummer: **88108833.0**

(22) Anmeldetag: **02.06.88**

(54) **Einrichtung zur digitalen Signalverarbeitung.**

(43) Veröffentlichungstag der Anmeldung:
**06.12.89 Patentblatt 89/49**

(45) Bekanntmachung des Hinweises auf die
Patenterteilung:
**29.12.93 Patentblatt 93/52**

(84) Benannte Vertragsstaaten:
**DE FR GB IT NL**

(56) Entgegenhaltungen:

**ELECTRONIC DESIGN, Band 34, Nr. 4, 20.
Februar 1986, Seiten 159-165, Hasbrouck
Heights, NJ, US; B. EICHEN et al.:
"Floating-point math integrated on chip makes DSP IC a standout"**

**ELEKTRONIK, Band 35, Nr. 18, 5. September
1986, Seiten 112-118,121-125, München, DE;
R. GLUTH: "Integrierte Signalprozessoren"**

(73) Patentinhaber: **Deutsche ITT Industries GmbH
Hans-Bunte-Strasse 19
D-79108 Freiburg(DE)**

(72) Erfinder: **Reich, Werner, Dr. Ing.
Kleiststrasse 2a
D-7830 Emmendingen(DE)**
Erfinder: **Gehrig, Wilfried, Werner, Dipl.-Ing.
Herrenstrasse 65
D-7806 March(DE)**

**Beschreibung**

Einrichtungen zur digitalen Signalverarbeitung enthalten im allgemeinen als Kernstück eine Prozessor-Einheit, welche die zugeführten Daten nach einer Programmabfolge verarbeitet, die von der gestellten Aufgabe abhängig ist, wobei jedoch die Möglichkeiten der vorgegebenen Schaltungseinrichtungen auf jeden Fall zu beachten sind. Die jeweilige Programmabfolge ist dabei entweder fest verdrahtet oder als Befehlsliste in einem Programmspeicher abgelegt, wobei meist eine Kombination aus beiden Möglichkeiten am effektivsten ist. Der Programmspeicher kann selbst ein Festprogrammspeicher ( = ROM) oder ein Schreib-Lese-Speicher ( = RAM) oder eine Kombination aus beiden sein. Wird der Prozessor in großen Stückzahlen produziert, dann befinden sich das feststehende Programm sowie die feststehenden Konstanten oder Koeffizienten meist im ROM und die zugehörigen variablen Daten im RAM.

Die eigentliche Signalverarbeitung findet in der arithmetisch-logischen Einheit ( = ALU) statt, die im allgemeinen einen Addierer oder einen Akkumulator, einen Multiplizierer und einige logische Grundschaltungen, z. B. eine Schiebeeinrichtung, enthält. Derartige integrierte Signalprozessoren sind in der Zeitschrifft Elektronic, Band 35, Nummer 5, September 1986, Seiten 112 bis 118 und 121 bis 129 beschrieben. Als zentales Steuerorgan dient meist der Programmspeicher, der je nach der auszuführenden Operation die erforderlichen Einzelsteuervorgänge auslöst, z.B. Datenbewegungen innerhalb der Recheneinheit oder zwischen dieser und den adressierbaren Speicherplätzen. Das gespeicherte Programm enthält dabei die unterschiedlichen Steuerbefehle direkt oder löst sie aus. Der zeitliche Ablauf ist durch den Programmzähler bewirkt.

Handelsübliche Prozessoren enthalten eine Vielzahl unterschiedlicher Befehle, die in einer Programmfolge zusammengefaßt werden können, um eine möglichst universelle Anwendbarkeit zu gewährleisten. Wo es auf diese nicht ankommt, kann der Prozessor wesentlich kleiner ausgebildet werden.

Es ist daher Aufgabe der im Anspruch 1 gekennzeichneten Erfindung, eine möglichst einfache integrierbare Prozessor-Einheit für eine bestimmte Verknüpfung von jeweils drei Operanden anzugeben, die beispielsweise in der digitalen Filtertechnik auftreten.

Weitere Ausführungsformen sind in den abhängigen Ansprüchen definiert.

Die Erfindung wird nun anhand der Figuren der Zeichnung näher erläutert:

Fig. 1 zeigt schematisch als Blockschaltbild ein Ausführungsbeispiel der Prozessor-Einheit nach der Erfindung, und

Fig. 2 zeigt als Schaltschema, wie ein rekursives Filter dritter Ordnung mittels der Prozessor-Einheit realisierbar ist.

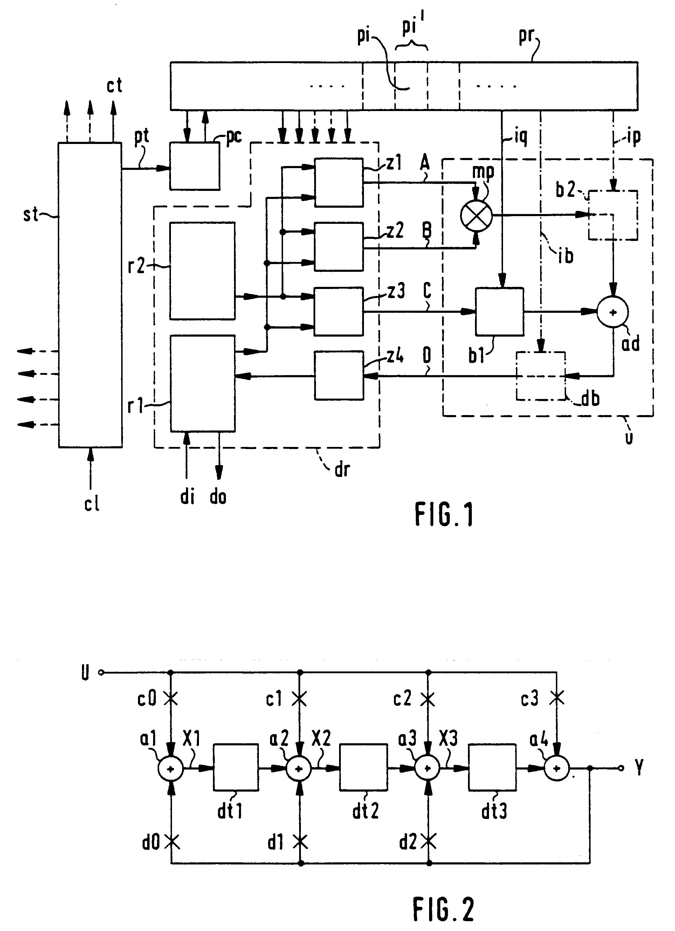

Das schematische Blockschaltbild Fig. 1 zeigt nur die wesentlichsten Teile der Prozessor-Einheit nach der Erfindung. Die Stromversorgung, die Erzeugung des Systemtakts cl und die Ein/Ausgabestufen sind z.B. nicht dargestellt. Dem einzigen Multiplizierer mp in der ALU ist das erste und das zweite Datenwort A, B zur Multiplikation zugeführt. Das der ALU, zugeführte dritte Datenwort C speist den Dateneingang der Schiebeeinrichtung, die durch den Barrel-Shifter b1 gebildet ist, dessen jeweiliger Schiebebefehl iq dem Programmspeicher pr entstammt. Der Ausgang des Barrel-Shifters b1 ist mit dem einen Eingang des Addierers ad verbunden, dessen anderer Eingang mit dem Ausgang des Multiplizierers mp gekoppelt ist. Der in Fig. 1 dargestellte weitere Barrel-Shifter b2, über den das Ausgangssignal des Multiplizierers mp geführt ist, kann in Ausgestaltung der Erfindung vorgesehen werden und ist daher strichpunktiert gezeichnet. Der zugehörige weitere Schiebebefehl ip entstammt ebenfalls dem Programmspeicher pr.

Mit den beiden Barrel-Shiftern b1, b2 wird im verwendeten Dualzahlensystem der zugeführte Zahlenwert mit einer Zweierpotenz multipliziert, wobei der Exponent eine positive oder negative ganze Zahl ist, die als Stellenverschiebungszahl q bzw. p dem ersten bzw. weiteren Barrel-Shifter b1, b2 mittels des jeweiligen Schiebebefehls iq, ip übermittelt ist.

Der Ausgang des Addierers ad liefert das vierte Datenwort D, das im Datenspeicher dr abgelegt wird. In Fig. 1 ist dabei eine weitere Ausgestaltung gezeigt, indem nämlich das vierte Datenwort D innerhalb der ALU über den Datenbegrenzer db geführt ist, der, mittels des Begrenzungsbefehls ib vom Programmspeicher pr aktiviert, das vierte Datenwort D in seinem Wert und damit den Datenüberlauffehler begrenzt.

Der in Fig. 1 dargestellte Datenspeicher dr enthält den Nur-Lese-Speicher ( = ROM) r2 zur Aufnahme von Konstanten und den Schreib-Lese-Speicher ( = RAM) r1 zur Aufnahme der von außen zugeführten Daten di oder der von der ALU erzeugten vierten Datenworte D.

Der Geschwindigkeitsanpassung des RAM- oder ROM-Speichers r1, r2 an die Verarbeitungsgeschwindigkeit der ALU dienen die vier Zwischenspeicher z1 ... z4, die jeweils eines der vier Datenwort A, B, C, D aufnehmen. Im vorliegenden Ausführungsbeispiel nach Fig. 1 ist die Zugriffszeit der RAM- oder ROM-Speicher r1, r2 wesentlich kleiner als die Ausführungszeit der ALU u, weshalb die Daten im Zeitmultiplexbetrieb über die Zwischenspeicher z1, z2, z3, z4 umgeladen werden. Die ersten drei Datenworte A, B, C entweder als interne Daten aus dem ROM-Speicher r2 oder als von außen zugeführte Daten di aus dem RAM-Speicher r1 auf den ersten, zweiten oder dritten Zwischenspeicher z1, z2, z3 geführt. Die entsprechenden Datenleitungen sind dargestellt. Der vierte Zwischenspeicher z4 schreibt die Ausgangsdaten in den RAM-Speicher r1, von wo sie als Ausgangsdaten do extern auslesbar sind. Die Adressensteuerung der Speicher erfolgt dabei durch vom Programmspeicher pr gesteuerte Steuersignale.

Der Aufruf der jeweiligen Steuersignale des Programmspeichers pr wird durch die ausgelesene Programmadresse pi′ bewirkt. Die Programmabfolge erfolgt durch die im Programmspeicher pr sequentiell gespeicherten Programmbefehle, mit denen die Prozessor-Einheit programmiert ist. Der Steuerung der Programmabfolge dient dabei der Programmzähler pc, der sowohl mit dem Steuerwerk st als auch mit dem Programmspeicher pr verbunden ist. Dabei erzeugt das Steuerwerk st aus dem Systemtakt cl den Zähltakt pt des Programmzählers pc und andere nicht näher beschriebene Takte des Systems, z.B. Abtasttakt ct.

Mittels eines einzigen Programmbefehls pi führt die Prozessor-Einheit folgende Rechenoperation aus:

$$D = AB + C2^q,$$

wobei beispielsweise als Programmbefehl pi: "D′, A′, B′, C′, q" im Programmspeicher pr abgespeichert ist. D′, A′, B′, C′ sind dabei die jeweiligen Adressen der vier zugehörigen Datenworte D, A, B, C im Datenspeicher dr und q ist die zugehörige Stelle-Verschiebungszahl des Barrel-Shifters b1. Dieser Befehl erlaubt die Realisierung einer für spezielle Anwendungen sehr vorteilhaften Prozessor-Einheit, auch wenn er nur als einziger Befehl zur Verfügung steht.

Mit dem im Ausführungsbeispiel nach Fig. 1 als Option angegebenen weiteren Barrel-Shifter b2 kann das Produkt AB nochmals mit einer Zweierpotenz multipliziert werden. Dies erweitert die oben beschriebene Grundoperation. Die Wirkung des ebenfalls als Option in der Prozessor-Einheit enthaltenen Datenbegrenzers db ergibt sich aus einer Begrenzungsfunktion, die z.B. bei einem Datenüberlauf die übergelaufene Zahl durch die höchst/niedrigst mögliche Zahl ersetzt.

Die vorteilhafte Verwendung der Prozessor-Einheit wird am Beispiel einer typischen Filterrealisierung gezeigt. Das in Fig. 2 dargestellte Strukturbild des Filters dritter Ordnung enthält als zeitvariable Eingangsgröße den mittels des Abtasttaktes ct gebildeten Digitalwert U. Dieser wird mit der ersten bzw. zweiten bzw. dritten bzw. vierten Konstanten c0, c1, c2, c3 multipliziert und jeweils auf den einen Eingang des ersten bzw. zweiten bzw. dritten bzw. vierten Addierers a1, a2, a3, a4 geführt.

Das zeitvariable Ausgangssignal des digitalen Filters ist der digitale Wert Y. Dieser wird mit der fünften bzw. sechsten bzw. siebten Konstanten d0, d1, d2, multipliziert und auf den zweiten Eingang des ersten bzw. zweiten bzw. dritten Addierers a1, a2, a3 geführt, dessen Ausgangssignal die erste bzw. zweite bzw. dritte digitale Zustandsvariable X1, X2, X3 ist, die mittels des ersten bzw. zweiten bzw. dritten Zustandspeichers dt1, dt2, dt3 verzögert und auf jeweils einen weiteren Eingang des zweiten bzw. dritten bzw. vierten Addierers a2, a3, a4 geführt ist. Die Verzögerungszeit der drei Zustandsspeicher ist sowohl im zeitlichen Ablauf als auch untereinander gleich.

Bei der Realisierung dieser Filterstruktur durch die erfindungsgemäße Prozessor-Einheit, werden die Zustandsvariablen X1, X2, X3 beispielsweise im Datenspeicher dr abgelegt und durch einen entsprechenden Programmbefehl pi wieder aufgerufen.

Mit der Prozessor-Einheit und dem Programmbefehl pi läßt sich die angegebene Filterstruktur stufenweise "abarbeiten. Die dreifach erforderliche Addition von jeweils drei Werten im zweiten und dritten Addierer a2, a3 erfolgt dabei über einen ersten Zwischenschritt, in dem zuerst zwei Größen zur Bildung eines weiteren Zwischenwertes addiert werden, zu dem dann in einem dritten Zwischenschritt die dritte Größe hinzuaddiert" wird. Da die Verarbeitungsgeschwindigkeit der Prozessor-Einheit im Vergleich zur Signalfrequenz sehr hoch und die ausgeführte Operation sehr effektiv ist, ergibt sich trotz der beschriebenen Zwischenschrittlösung eine äußerst kurze Programmabfolge. Der durch den Programmzähler pc gesteuerte zyklische Programmablauf muß aber mindestens innerhalb der durch den Abtasttakt ct gebildeten Abtastzeit abgeschlossen sein.

In Fig. 2 ist ein rekursives Filter dritter Ordnung schematisch mit seinem Signalflußgraphen dargestellt. Die Übertragungsfunktion lautet

$$H(z) = (z^3 a3 + z^2 a2 + za1 + a0)/(z^3 + z^2 b2 + zb1 + b0)$$

Eine für die beschriebene Prozessor-Einheit geeignetere Darstellung derselben Übertragungsfunktion lautet:

$$H(z) = v(z^3 c3 + z^2 c2 + zc1 + c0)/(z^3 - z^2 d2 - zd1 - d0)$$

mit $c_0 = 2q$, $v = a_0/c_0$, $c_3 = a_3/v$, $c_2 = a_2/v$,
$c_1 = a_1/v$, $d_2 = -b_2$, $d_1 = -b_1$, $d_0 = -b_0$.

In der zweiten Darstellung ist eine Konstante v derart aus dem Zähler der Übertragungsfunktion ausgeklammert, daß der Koeffizient $c_0$ zu einer Zweierpotenz wird. Sieht man vom Koeffizienten v ab, so hat man hierdurch eine echte Multiplikation gegen eine einfachere Multiplikation mit einer Zweierpotenz eingetauscht. Da man in vielen Anwendungen eine Kaskade von Filtern zu realisieren hat, braucht man das Produkt aller Koeffizienten v der einzelnen Filter nur einmal als echte Multiplikation auszuführen, z.B. am Anfang oder am Ende der Kaskade. Diese Vorgehensweise ist besonders dann effizient, wenn - wie sehr häufig der Fall - die Kaskade aus Teilfiltern 1 und/oder 2. Ordnung besteht.

Die in der nachfolgenden "Tabelle mit Filterberechnungsbeispiel" angegebenen Gleichungen ergeben sich aus dem Strukturbild des in Fig. 2 als Beispiel dargestellten Filters. Im linken Tabellenteil sind dabei die Gleichungen angegeben mit denen das Filter dritter Ordnung implementiert werden kann, abgesehen vom Vorfaktor v. Auf der rechten Seite der Tabelle stehen dabei die zugehörigen Programmbefehle pi. Zwei Gleichungen müssen dabei in je zwei Programmschritten abgearbeitet werden. Die auf der rechten Seite angegebene Programmfolge zeigt, daß das Filter mit sechs aufeinanderfolgenden Instruktionen ausgeführt werden kann. Allgemein kann ein Filter N-ter Ordnung durch 2N Instruktionen implementiert werden. Dies zeigt, daß die als Grundoperation verwendete Instruktion sehr leistungsfähig ist.

**Tabelle mit Filterberechnungsbeispiel:**

$Y = X3 + Uc3$              p1: Y, c3, U, X3, 0

$X3 = X2 + Uc2 + Yd2$       p2: X3, c2, U, X2, 0

                           p3: X3, d2, Y, X3, 0

$X2 = X1 + Uc1 + Yd1$       p4: X2, c1, U, X1, 0

                           p5: X2, d1, Y, X2, 0

$X1 = Uc0 + Yd0$            p6: X1, d0, Y, U, q.

An der vorgestellten ALU u von Fig. 1 fällt auf, daß sie keinen Akkumulator besitzt. Dies ist vorteilhaft, wenn die ALU in Pipeline-Technik betrieben wird. In diesem Fall ist das Ergebnis D einer Operation im nächsten Instruktionszyklus noch nicht verfügbar, sondern je nach der Tiefe der Pipeline-Verarbeitung erst erhebliche Zeit später. Um trotz dieser Wartezeit keine Prozessorzeit zu verlieren, kann man die aufeinanderfolgenden Instruktionen mehrerer Prozesse gegenseitig verschränken (interleaven). Ist z.B. das Ergebnis D erst nach drei

Programmschritten verfügbar, so hat ein effizientes Programm folgende Struktur:

Operation 1 von Prozeß 1
Operation 1 von Prozeß 2
Operation 1 von Prozeß 3
Operation 2 von Prozeß 1
Operation 2 von Prozeß 2
Operation 2 von Prozeß 3
Operation 3 von Prozeß 1
usw.

## EP 0 344 347 B1

**Patentansprüche**

1. Prozessor-Einheit mit folgenden Teilschaltungen:
   - einem Steuerwerk (st), einem Programmspeicher (pr), einem Datenspeicher (dr) und einer arithmetisch-logischen Einheit (u), die einen Addierer (ad), einen Multiplizierer (mp) und ein Barrel-Shifter (b1) als Schiebeeinrichtung enthält, wobei dem ersten und zweiten Eingang des einzigen Multiplizierers (mp) ein aus dem Datenspeicher (dr) stammendes erstes bzw. zweites Datenwort A bzw. B zugeführt ist,
   gekennzeichnet durch folgende Merkmale:
   - dem Dateneingang des Barrel-Shifters (b1) ist ein drittes aus dem Datenspeicher (dr) stammendes Datenwort C zugeführt, dessen Stellen-Verschiebungszahl q mittels eines aus dem Programmspeicher (pr) stammenden Schiebebefehls (iq) bestimmt ist, und
   - der Ausgang des Multiplizierers (mp) und der Ausgang des Barrel-Shifters (b1) sind jeweils mit einem Eingang des einzigen Addierers (ad) verbunden, dessen Ausgangssignal als ein viertes Datenwort $D = A * B + C * 2^q$ in den Datenspeicher (dr) eingeschrieben wird.

2. Prozessor-Einheit nach Anspruch 1, dadurch gekennzeichnet, daß mittels eines im Programmspeicher (pr) abgelegten Programmbefehls (pi) die ALU (u) aus den Datenworten A, B, C das vierte Datenwort D bildet.

3. Prozessor-Einheit nach Anspruch 2, dadurch gekennzeichnet, daß der Programmbefehl (pi) die Lese- und Schreib-Adressen der vier Datenworte A, B, C, D sowie die Stellen-Verschiebungszahl q enthält.

4. Prozessor-Einheit nach Anspruch 3, dadurch gekennzeichnet, daß zwischen dem Ausgang des Multiplizierers (mp) und dem zugehörigen Eingang des Addierers (ad) ein weiterer Barrel-Shifter (b2) eingefügt ist, dessen Stellen-Verschiebungszahl p durch einen weiteren aus dem Programmspeicher (pr) stammenden Schiebebefehl (ip) bestimmt und im Programmbefehl (pi) enthalten ist.

5. Prozessor-Einheit nach Anspruch 4, dadurch gekennzeichnet, daß dem Ausgang des Addierers (ad) ein Datenbegrenzer (db) unmittelbar nachgeschaltet ist, der das Datenwort D in seinem Wert begrenzt, und daß der Programmspeicher (pr) den Datenbegrenzer (db) mittels eines Begrenzungsbefehls (ib) aktiviert, der im Programmbefehl (pi) enthalten ist.

6. Prozessor-Einheit nach einem der Ansprüche 1 bis 5, dadurch gekennzeichnet, daß zwischen der ALU (u) und dem Datenspeicher (dr) mindestens vier Zwischenspeicher (c1, c2, c3, c4) für die vier Datenworte A, B, C, D eingefügt sind.

7. Prozessor-Einheit nach einem der Ansprüche 2 bis 6, dadurch gekennzeichnet, daß mittels einer aus dem Programmbefehl (pi) gebildeten Befehlsfolge ein digitales Filter realisiert ist.

8. Prozessor-Einheit nach einem der Ansprüche 1 bis 7, dadurch gekennzeichnet, daß die Prozessor-Einheit als einzigen Befehl den Programmbefehl (pi) verarbeitet, der als Erweiterung die weitere Stellen-Verschiebungszahl p und den Begrenzungsbefehl (ib) enthalten kann.

**Claims**

1. A processor comprising the following subcircuits:
   - a control unit (st), a program memory (pr), a data memory (dr), and an arithmetic/logic unit (u) which includes an adder (ad), a multiplier (mp), and a barrel shifter (b1) as a shifting device, the first and second inputs of the sole multiplier (mp) being fed with a first data word A and a second data word B, respectively, from the data memory (dr);
   characterized by the following features:
   - The data input of the barrel shifter (b1) is fed from the data memory (dr) with a third data word C whose shift number q is determined by means of a shift instruction (iq) from the program memory (pr), and
   - the output of the multiplier (mp) and the output of the barrel shifter (b1) are each connected to one input of a single adder (ad) whose output signal is written as a fourth data word $D = A * B + C * 2^q$ into the data memory (dr).

5

**2.** A processor as claimed in claim 1, characterized in that in response to a program instruction (pi) stored in the program memory (pr), the ALU (u) forms the fourth data word D from the data words A, B, C.

**3.** A processor as claimed in claim 2, characterized in that the program instruction (pi) contains the read and write addresses of the four data words A, B, C, D and the shift number q.

**4.** A processor as claimed in claim 3, characterized in that an additional barrel shifter (b2) is inserted between the output of the multiplier (mp) and the associated input of the adder (ad),and that its shift number p is determined by an additional shift instruction (ip) from the program memory (pr) and contained in the program instruction (pi).

**5.** A processor as claimed in claim 4, characterized in that the output of the adder (ad) is directly followed by a data limiter (db) which limits the data word D in its value, and that the program memory (pr) activates the data limiter (db) by means of a limiting instruction (ib) included in the program instruction (pi).

**6.** A processor as claimed in any one of claims 1 to 5, characterized in that at least four buffers (c1, c2, c3, c4) for the four data words A, B, C, D are interposed between the ALU (u) and the data memory (dr).

**7.** A processor as claimed in any one of claims 2 to 6, characterized in that a digital filter is realized by means of an instruction sequence formed from the program instruction (pi).

**8.** A processor as claimed in any one of claims 4 to 7, characterized in that the only instruction processed by the processor is the program instruction (pi), which may include the additional shift number p and the limiting instruction (ib) as an extension.

**Revendications**

**1.** Processeur comprenant les parties de circuit suivantes :
- une unité de commande (st), une mémoire de programme (pr), une mémoire de données (dr) et une unité arithmétique et logique (u) qui comprend un additionneur (ad), un multiplieur (mp) et un dispositif à décalage circulaire (b1) comme dispositif à décalage, dans lequel un premier ou un deuxième mots de données, A ou B, provenant de la mémoire de données (dr) est envoyé respectivement à la première et à la deuxième entrées du multiplieur unique (mp),
  caractérisé en ce que
- un troisième mot de données C provenant de la mémoire de données (dr) est envoyé à l'entrée de données du dispositif à décalage circulaire (b1),dont le nombre de chiffres de décalage q est déterminé au moyen d'une instruction de décalage (iq) provenant de la mémoire de programme (pr) et
- la sortie du multiplieur (mp) et la sortie du dispositif à décalage circulaire (b1) sont reliées respectivement à une entrée de l'additionneur unique (ad) dont le signal de sortie est inscrit dans la mémoire de données (dr) comme un quatrième mot de données $D = A * B + C * 2^q$.

**2.** Processeur selon la revendication 1, caractérisé en ce qu'au moyen d'une instruction de programme (pi) stockée dans la mémoire de programme (pr) l'unité arithmétique et logique (u) forme le quatrième mot de données D à partir des mots de données A, B ,C.

**3.** Processeur selon la revendication 2, caractérisé en ce que l'instruction de programme (pi) comprend les adresses de lecture et d'écriture des quatre mots de données A, B, C, D ainsi que le nombre de décalage de chiffres q.

**4.** Processeur selon la revendication 3, caractérisé en ce qu'entre la sortie du multiplieur (mp) et l'entrée appartenant à l'additionneur (ad) un autre dispositif à décalage circulaire (b2) est inséré, dont le nombre de décalages de chiffres p est déterminé par une autre instruction de décalage (ip) provenant de la mémoire de programme (pr) et est contenu dans l'instruction de programme (pi).

**5.** Processeur selon la revendication 4, caractérisé en ce qu'un limiteur de données (db), qui limite dans sa valeur le mot de données D, est branché immédiatement après la sortie de l'additionneur (ad), et que la mémoire de programme (pr) active le limiteur de données (db) au moyen d'une instruction de limitation (ib) qui est contenue dans l'instruction de programme (pi).

**6.** Processeur d'après l'une quelconque des revendications 1 à 5, caractérisé en ce qu'entre l'unité arithmétique et logique (u) et la mémoire de données (dr) au moins quatre mémoires intermédiaires (c1, c2, c3, c4) sont introduites pour les quatre mots de données A, B, C, D.

**7.** Processeur d'après l'une quelconque des revendications 2 à 6, caractérisé en ce que, au moyen de l'une des séquences d'instructions formées à partir de l'une des instructions de programme (pi), on réalise un filtre numérique.

**8.** Processeur d'après l'une quelconque des revendications 1 à 7, caractérisé en ce que le processeur traite comme instruction unique l'instruction de programme (pi) qui peut contenir comme extension l'autre nombre de décalage de chiffres p et l'instruction de limitation (ib).

FIG.1

FIG.2